(19) Europäisches Patentamt European Patent Office Office européen des brevets

(11) **EP 2 929 934 B1**

(12) **EUROPEAN PATENT SPECIFICATION**

(45) Date of publication and mention
of the grant of the patent:
**30.01.2019  Bulletin 2019/05**

(21) Application number: **14864305.9**

(22) Date of filing: **21.11.2014**

(51) Int Cl.:
**B01J 20/04** *(2006.01)*      **B01J 20/28** *(2006.01)*

(86) International application number:
**PCT/KR2014/011248**

(87) International publication number:
**WO 2015/076610 (28.05.2015 Gazette 2015/21)**

(54) **GETTER MATERIAL AND HYGROSCOPIC FILM COMPRISING SAME**

GETTERMATERIAL UND HYGROSKOPISCHER FILM DAMIT

MATÉRIAU PIÉGEUR ET FILM HYGROSCOPIQUE LE COMPRENANT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **21.11.2013  KR 20130142079**

(43) Date of publication of application:
**14.10.2015  Bulletin 2015/42**

(73) Proprietor: **LG Chem, Ltd.
Seoul 150-721 (KR)**

(72) Inventors:
 • **LEE, Su Hee
   Daejeon 305-738 (KR)**
 • **BYUN, Won Bae
   Daejeon 305-738 (KR)**
 • **KIM, Dong Hwan
   Daejeon 305-738 (KR)**
 • **PARK, Cheol Hee
   Daejeon 305-738 (KR)**
 • **PARK, Chee Sung
   Daejeon 305-738 (KR)**

(74) Representative: **Goddar, Heinz J.
Boehmert & Boehmert
Anwaltspartnerschaft mbB
Pettenkoferstrasse 22
80336 München (DE)**

(56) References cited:
**WO-A1-2013/153469       KR-A- 20090 031 591
KR-A- 20110 064 670       KR-A- 20120 021 436
KR-A- 20130 019 966       US-A1- 2002 035 032
US-A1- 2003 102 099       US-A1- 2006 097 633
US-A1- 2014 166 927**

**Description**

[Technical Field]

The present application relates to an absorptive film comprising a gettering agent and an organic electronic device.

[Background Art]

An organic electronic device (OED) includes one or more layers of an organic material that can conduct an electric current. A type of the organic electronic device includes an organic light emitting device (OLED), an organic solar cell, an organic photoconductor (OPC), or an organic transistor.
Generally, the organic light emitting device, which is a representative organic electronic device, typically includes a substrate, a first electrode layer, an organic layer, and a second electrode layer in order. In the structure that is known as a bottom emitting device, the first electrode layer may be formed as a transparent electrode layer and the second electrode layer may be formed as a reflective electrode layer. In addition, in the structure that is known as a top emitting device, the first electrode layer may be formed as a reflective electrode layer and the second electrode layer may be formed as a transparent electrode layer. An electron and a hole injected by an electrode layer may be recombined on an emitting layer that is provided on the organic layer, thereby generating light. The light may be emitted to the side of the substrate in the bottom emitting device and may be emitted to the side of the second electrode layer in the top emitting device.
There is durability as an important issue to be considered in an organic electronic device. It is very easy to oxidize an organic layer or electrode due to foreign materials, such as, moisture or oxygen, and thus, it is important to secure durability against environmental factors. In this regard, Patent Documents 1 to 4 suggest the structure that can block the penetration of foreign materials.

[Prior Art Document]

[Patent Document]

Patent Document 1: US Patent No. 6,226,890
Patent Document 2: US Patent No. 6,808,828
Patent Document 3: Japanese Laid-Open Patent Publication No. 2000-145627
Patent Document 4: Japanese Laid-Open Patent Publication No. 2001-252505

US 2006/097633 A1 discloses an organic electroluminescent device which includes a substrate, an encapsulation substrate, an organic electroluminescent portion comprising a first and second electrode and an organic layer interposed between the substrate and the encapsulation substrate and a transparent moisture absorption layer, which is either coated on an inner surface of the encapsulation substrate, or formed on the upper surface of the second electrode. The transparent moisture absorption layer comprises at least one of a metal oxide and a metal salt with an average particle diameter of about 100 nm or less, a binder - which can be an inorganic binder, and a dispersant which can include a metal alkoxide compound.
US 2002/035032 A1 discloses a composite material comprising metal oxide/metal hydroxide particles coated with a second metal oxide or a metal nitrate, where the composite has 90-99% by weight of the first metal oxide/metal hydroxide and an average particle size of up to 21 nm.

[Disclosure]

[Technical Problem]

The present invention is directed to providing an absorptive film including a gettering agent, which is provided on a front side or back side of an organic electronic device and effectively absorbs and blocks moisture, and thus, can improve durability and lifespan of the organic electronic device.

[Technical Solution]

The present application relates to an absorptive film comprising a gettering layer having a gettering agent, wherein the gettering agent comprises first moisture absorbent particles, which have an average particle size in a range of 20 nm to 100 nm; and second moisture absorbent particles, which surround a surface of each first moisture absorbent particle and have a lower rate of moisture absorption than the first moisture absorbent particles,

wherein the first moisture absorbent particle is CaO and the second moisture absorbent particle is MgO,

wherein the particle size of the particles is measured by a scanning electron microscope (SEM) image,

wherein the rate of moisture absorption of the first and the second absorbent particles is calculated after the first or second moisture absorbent particles in a state of having a moisture content of 0 to 0.1 wt% are maintained at 25°C and a relative humidity of 70% for 1 hour, and

wherein the gettering agent has 8 wt% or less of a moisture content, which is calculated after the gettering agent in a state of having the moisture content of 0 to 0.1 wt% is maintained at 25°C and a relative humidity of 70% for 1 hour.

In the present specification, the term, "organic electronic device" refers a product or device having a structure that includes an organic material layer generating an alternating current of electric charge using a hole and an electron between a pair of mutually-opposite electrodes, and examples thereof may include a photovoltaic device, a rectifier, a transmitter, and an organic light emitting device (OLED), but the present invention is not limited thereto. In one example of the present invention, the organic electronic device may be an OLED.

The gettering agent includes first moisture absorbent particles and second moisture absorbent particles surrounding the surface of the first moisture absorbent particles. The second moisture absorbent particles have an absorbing property, which is a rate of moisture absorption lower than that of the first moisture absorbent particles. In addition, the average particle size of the first moisture absorbent particles is within the range of 20 nm to 100 nm.

The gettering agent is maintained at 25°C and a relative humidity of 70% for 1 hour in a state of having a moisture content of 0 to 0.1 wt%, and then, the moisture content calculated in the gettering agent is 8 wt% or less or may be 7 wt% or less. In the present specification, the moisture content in the gettering agent after maintaining for 1 hour may be defined as an initial rate of moisture absorption of the gettering agent, and the lower limit thereof is not particularly limited, but may be 0 wt%, 0.1 wt%, or 1 wt%. In the present application, it is possible to suppress sudden moisture absorption by the gettering agent during an initial process as described above, and thus, the moisture absorbent particles having a particle size of a nano size may form the gettering agent. Therefore, it is possible to implement the transparency of an absorptive film including the gettering agent.

In one example, the gettering agent may satisfy the following Equation 1.

$$[\text{Equation 1}]$$

$$Y/X \geq 7$$

In Equation 1, X represents the moisture content in a gettering agent, which is calculated after the gettering agent in the state of having the moisture content of 0 to 0.1 wt% is maintained at 25°C and a relative humidity of 70% for 1 hour. In addition, Y represents the moisture content in a gettering agent, which is calculated after the gettering agent in the state of having the moisture content of 0 to 0.1 wt% is maintained at 25°C and a relative humidity of 70% for 72 hours. In other words, according to the gettering agent of the present application, it is possible to maintain an initial rate of moisture absorption to be low, and also, the total amount of moisture that can be absorbed by the gettering agent to be high. Here, Y/X may be 7 to 30 or 8 to 25.

The rate of moisture absorption of the second moisture absorbent particles is lower than the rate of moisture absorption of the first moisture absorbent particles. As described above, by the second moisture absorbent particles having a low rate of moisture absorption, which are provided on the surface of the first moisture absorbent particles, the sudden moisture absorption may be suppressed during preparing a gettering agent under a general atmosphere environment. In one example, the moisture content in the first moisture absorbent particle, which is calculated after the first moisture absorbent particles in the state of having the moisture content of 0 to 0.1 wt% are maintained at 25°C and a relative humidity of 70% for 1 hour, may be 10 wt% to 30 wt%, 10 wt% to 25 wt%, 11 wt% to 23 wt%, or 12 wt% to 20 wt%. In addition, the moisture content in the second moisture absorbent particles, which is calculated after the second moisture absorbent particle in the state of having the moisture content of 0 to 0.1 wt% are maintained at 25°C and a relative humidity of 70% for 1 hour, may be 1 wt% to 9 wt%, 1 wt% to 8 wt%, 1 wt% to 7 wt%, 1 wt% to 6 wt%, 2 wt% to 5 wt%, or 2.5 wt% to 4.5 wt%. The moisture content may refer to a rate of moisture absorption that absorbs moisture by reacting the moisture absorbent particle with atmospheric moisture over time.

In a specific example of the present application, the rate of moisture absorption of the first moisture absorbent particles, which is calculated after the first moisture absorbent particles in the state of having the moisture content of 0 to 0.1 wt% are maintained at 25°C and a relative humidity of 70% for 1 hour, may be 2 times to 20 times, 2 times to 16 times, 3 times to 12 times, or 3 times to 10 times higher than the rate of moisture absorption of the second moisture absorbent particle. The second moisture absorbent particles are located on the surface of the first moisture absorbent particles, and thus, directly in contact with the moisture in the air, and by controlling the rate of moisture absorption of the second moisture absorbent particles as described above, it may be possible to provide a reliable absorptive film to be desired. In other words, since the second moisture absorbent particles are exposed in the air during performing the process, it is possible to control the sudden moisture absorption by the second moisture absorbent particles having a relatively low initial rate of moisture absorption, and also, after completing the process, the absorbent film including the gettering agent can implement the effective block of moisture absorption by the first moisture absorbent particles having a high rate of moisture absorption. In addition, by controlling the sudden moisture absorption as described above, the absorbent particle may be formed in a nano size. In other words, in general, the particle size of the absorbent particle used for a gettering agent is 0.5 to 2 μm. When the particle size thereof is smaller than the above size, the absorbent particle suddenly reacts with atmospheric moisture during performing the process, thereby reducing the total amount of moisture absorption. According to the present application, the sudden moisture absorption may be suppressed as described above, and thus, the moisture absorbent particle having a particle size of a nano size may form a gettering agent. Therefore, it is possible to implement the transparency of absorptive film including the gettering agent. By such a transparent absorptive film, it is possible to implement an OLED in a way of top-emitting.

In the present specification, the term, "moisture absorbent particle" or "moisture absorbing particle" is a composition that forms a gettering agent, and may refer to the first moisture absorbent particles or the second moisture absorbent particles and also to particles itself, in which the second moisture absorbent particles surround the surface of the first moisture absorbent particles.

In one example, the average particle size of the first moisture absorbent particle may be 20 nm to 100 nm, 20 nm to 90 nm, 20 nm to 80 nm, 20 nm to 70 nm, 20 nm to 60 nm, 20 nm to 50 nm, or 20 nm to 40 nm. Here, the particle size of the particle may be measured by a scanning electron microscope (SEM) image, for example. When the average particle size of the first moisture absorbent particles is less than 10 nm, there is a problem in that a specific surface area is very large, and thus, it is difficult to uniformly disperse the particles in a solvent, thereby having an adverse effect on workability. When the average particle size of the first moisture absorbent particles exceeds 100 nm, it is difficult to secure the transparency during manufacturing an absorptive film with a gettering agent. In addition, in one example, the average particle size of the second moisture absorbent particles may be 5 nm to 20 nm, 5 nm to 18 nm, 6 nm to 16 nm, 6 nm to 14 nm, or 8 nm to 12 nm, and may surround the surface of the first moisture absorbent particles. When the average particle size of the second moisture absorbent particles is less than 5 nm, it is difficult to effectively control the sudden moisture absorption of the moisture during processing the process, because the thickness of the particles surrounding the surface of the first moisture absorbent particle is too thin. When the average particle size of the second moisture absorbent particles exceeds 20 nm, it is difficult to effectively block the moisture and also to secure the transparency of the absorptive film after manufacturing a final absorptive film.

Especially, the absorptive film including the gettering agent may secure the transparency due to the first moisture absorbent particles and the second moisture absorbent particles, which are controlled to have a specific size. Therefore, the absorptive film may be positioned on the back side and also on the front side that emits light during encapsulating an organic electronic device, and thus, it is possible to implement a top emitting device without largely changing the structure and manufacturing process of a bottom emitting device that is currently commercialized. In addition, the absorptive films are on both sides, and thus, it is effective to absorb and block moisture.

In one example, the second moisture absorbent particles may be included in the amount of 5 to 20 parts by weight, 5 to 18 parts by weight, or 8 to 15 parts by weight with respect to 100 parts by weight of the first moisture absorbent particles. By controlling the content of the second moisture absorbent particles to be within the above range, it is possible to effectively surround the first moisture absorbent particles and to control an initial rate of moisture absorption to be in the proper range.

In the present application, a method for performing the surface treatment of the first moisture absorbent particles with the second moisture absorbent particles is as follows. The precursor of the first moisture absorbent particle is added in an organic solvent, and then, the agglomerated powder particles are dispersed by a ball mill process. To the dispersed slurry thus obtained, 0.5 to 3 wt% of the alkoxide compound precursor of the second moisture absorbent particles is added, and then, stirred. 0.1 to 0.5 wt% of an acetic acid solution is added thereto, and then, the solution thus obtained is further stirred to perform hydrolysis. Since then, the reactant is separated by a centrifuge so as to separate a solid content and a solvent. The solid content powder is dried in a vacuum drier while maintaining the temperature at 80°C, and then, is subjected to calcinations at 700°C under a nitrogen atmosphere to obtain the moisture absorbent particles, in which the second moisture absorbent particles are treated on the surface of the first moisture absorbent particles.

The absorptive film has a gettering layer including the gettering agent described above. The gettering layer may have a shape of film or sheet. Such a gettering layer may be used for encapsulating an organic electronic device.

The absorptive film may further include a substrate film or a releasing film (in some cases, the film may be referred to hereinafter as "a first film"), may have the structure, in which the gettering layer is formed on the substrate film or the releasing film. In addition, the structure may further include a substrate or releasing film (in some cases, the film may be referred to hereinafter as "a second film") formed on the gettering layer.

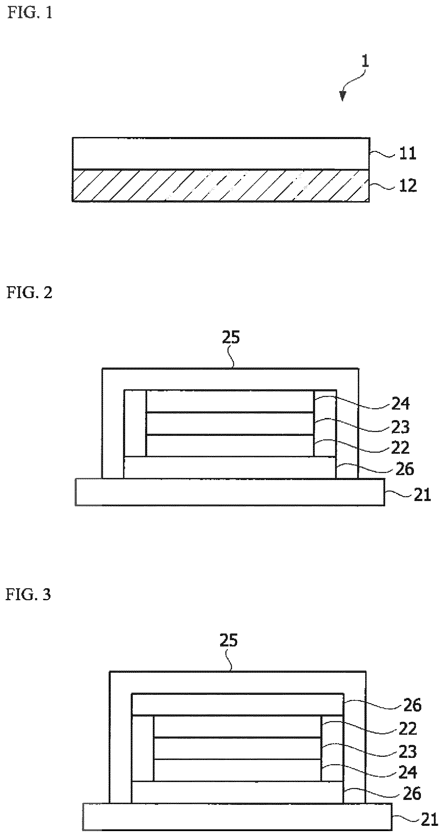

FIG. 1 illustrates a cross-sectional diagram of an exemplary absorptive film.

As illustrated in FIG. 1, an absorptive film 1 may include a gettering layer 11 formed on a substrate or releasing film 12. The absorptive film may have the structure that includes only a gettering layer in a shape of a film or sheet maintaining a solid phase or semi-solid phase at room temperature because of having the gettering agent without a supporting substrate, such as a substrate or releasing film; the structure having the gettering layer being formed on both sides of one substrate or releasing film; or the structure, in which a substrate or releasing film is formed on both sides of the gettering layer (not illustrated in drawings).

A specific type of the first film is not particularly limited. For example, as the first film, a plastic film may be used. Examples of the first film may include a polyethyleneterephthalate film, a polytetrafluoroethylene film, a polyethylene film, a polypropylene film, a polybutene film, a polybutadiene film, a vinyl chloride copolymer film, a polyurethane film, an ethylene-vinyl acetate film, an ethylenepropylene copolymer film, an ethylene-acrylic acid ethyl copolymer film, an ethylene-acrylic acid methyl copolymer film, or a polyimide film.

When the first film is a releasing film, a proper release treatment may be performed on one side or both sides of the plastic film described above. Examples of the releasing agent that is used for a release treatment may include an alkyd-based releasing agent, a silicon-based releasing agent, a fluorine-based releasing agent, an unsaturated ester-based releasing agent, a polyolefin-based releasing agent, or an wax-based releasing agent. In consideration of heat resistance, among them, an alkyd-based releasing agent, a silicon-based releasing agent, or a fluorine-based releasing agent is generally used, but the present invention is not limited thereto.

A type of the second film is not particularly limited, either. For example, as the second film, a type that is the same as the first film or different from the first film may be used within the exemplified range for the first film described above.

The thickness of the first or second film is not particularly limited. In one example, the thickness of the first film may be about 50 μm to 500 μm or 100 μm or 200 μm. Within the above range, the process for manufacturing a gettering agent or an organic electronic device may be effectively automated, and also it is financially lucrative.

The thickness of the second film is not particularly limited, either. For example, the thickness of the second film may be the same as the thickness of the first film or may be controlled to be relatively thinner or thicker than the first film.

The thickness of the gettering layer is not particularly limited, and may be properly selected in consideration of a use thereof. For example, the thickness of the gettering layer may be about 5 μm to 200 μm. For example, the thickness of the gettering layer may be controlled in consideration of an embedding property, workability, or economic feasibility when being used as an encapsulant for an organic electronic device.

In addition, the absorptive film may have excellent light transmittance in the visible ray area. In one example, the present application may exhibit 88% or more of light transmittance with respect to the visible ray area. In the present application, the absorptive film including the gettering agent may maintain the transparency, excellently. For example, the gettering layer, which is formed by applying and drying the gettering agent prepared by combining the first moisture absorbent particle and the second moisture absorbent particle that are controlled to have a specific size, to be 50 μm of the thickness after drying, may have the light transmittance of 88% or more, 89% or more, 90% or more, 91% or more, or 92% or more, with respect to the visible ray area. The light transmittance may be measured at 440 nm using a UV/Vis spectrometer.

In addition, the absorptive film may exhibit excellent light transmittance and also low haze. In one example, when the first moisture absorbent particles and the second moisture absorbent particles are combined as described above, it is possible to provide the absorptive film having low haze. For example, the gettering layer that is formed under the same condition as the condition for measuring light transmittance may exhibit the haze of less than 3%, less than 2.9%, or less than 2.8%. The haze may be measured according to a standard test method of ASTM D 1003 using a haze meter.

In a specific embodiment of the present application, the gettering layer of the absorptive film may include a base resin. In one example, the base resin may be a curable resin. As the curable resin, a heat-curable resin, an active energy ray-curable resin, or a hybrid-curable resin, which is known in the art, may be used. In the present specification, "the heat-curable resin" may refer to a resin cured by an aging process or supply of proper heat, "the active energy ray-curable resin" may refer to a resin cured by irradiation of an active energy ray, and "the hybrid-curable resin" may refer to a resin cured by performing the curing mechanisms of heat-curable resin and active energy ray-curable resin at the same time or in order. In addition, here, examples of the active energy ray may include microwaves, IR, UV, X rays, and gamma rays, a particle beam, such as, an alpha-particle beam, a proton beam, a neutron beam, or an electron beam, or the like.

Examples of the curable resin may include, as a resin that can exhibit an adhesive property after being cured, the resin including one or more functional groups or regions that can be cured by heat, such as a glycidyl group, an isocyanate group, a hydroxyl group, a carboxyl group, or an amide group, or the resin including one or more functional groups or regions that can be cured by the irradiation of the active energy rays, such as an epoxide group, a cyclic ether group, a sulfide group, an acetal group, or a lactone group. Examples of the curable resin may include an acrylic resin, a polyester resin, an isocyanate resin, or an epoxy resin, which has one or more functional groups or regions as described above, but the present invention is not limited thereto.

In one example, an epoxy resin may be used as the curable resin. The epoxy resin may be an aromatic-based or aliphatic-based epoxy resin. As the epoxy resin, a heat-curable epoxy resin may be used, or an active energy ray-curable resin, which is cured by a cationic polymerization reaction by the irradiation of active energy rays, for example, may be used.

The epoxy resin according to one example may have an epoxy equivalent of 150 g/eq to 2,000 g/eq. Within the above-described epoxy equivalent, the properties, such as, a glass transition temperature or an adhesive performance of the cured product may be maintained in a proper range.

A type of a curing agent may be properly selected and used according to a type of a curable resin or the functional group that is included in the resin.

In one example, when the curable resin is an epoxy resin, as a curing agent, the curing agents of the epoxy resins that are known in the art, for example, an amine curing agent, an imidazole curing agent, a phenol curing agent, a phosphorus curing agent, or an acid anhydride curing agent, may be used alone or in combination of two or more thereof, but the present invention is not limited thereto.

In one example, as the curing agent, an imidazole compound that is a solid phase at room temperature and has a melting point or a decomposition temperature of 80°C or higher may be used. Examples of the compound may include 2-methyl imidazole, 2-heptadecyl imidazole, 2-phenyl imidazole, 2-phenyl-4-methyl imidazole, or 1-cyanoethyl-2-phenyl imidazole, but the present invention is not limited thereto.

The content of the curing agent may be selected according to a type or a rate of the composition, for example, a curable resin. For example, the curing agent may be included in the amount of 1 part by weight to 20 parts by weight, 1 part by weight to 10 parts by weight, or 1 part by weight to 6 parts by weight, with respect to 100 parts by weight of the curable resin. However, the weight rate may be changed according to a type and ratio of the curable resin or the functional group of the resin, or a crosslink density to be implemented.

When the curable resin is an epoxy resin that can be cured by the irradiation of the active energy rays, for example, a cationic photo-polymerization initiator may be used as an initiator.

As the cationic photo-polymerization initiator, an onium salt or an organometallic salt-based ionized cationic initiator or an organosilane or latent sulfonic acid-based non-ionized cationic photo-polymerization initiator may be used. Examples of the onium salt-based initiator may include a diaryliodonium salt, a triarylsulfonium salt, an aryldiazonium salt, or the like; examples of the organometallic salt-based initiator may include iron arene, or the like; examples of the organosilane-based initiator may include o-nitrobenzyl triaryl silyl ether, triaryl silyl peroxide, acyl silane, or the like; and examples of latent sulfonic acid-based initiator may include $\alpha$-sulfonyloxy ketone, $\alpha$-hydroxymethylbenzoin sulfonate, or the like, but the present invention is not limited thereto.

In one example, as a cationic initiator, an ionized cationic photo-polymerization initiator may be used.

The content of the initiator may be changed according to a type and ratio of the curable resin or the functional group of the resin, or a crosslink density to be implemented as the curing agent. For example, the initiator may be combined in the ratio of 0.01 part by weight to 10 parts by weight or 0.1 part by weight to 3 parts by weight, with respect to 100 parts by weight of the curable resin. When the content of the initiator is excessively small, the curing may not be performed sufficiently and when the content of the initiator is excessively large, the content of ionic materials increases after curing, thereby decreasing the durability of adhesive or forming a conjugate acid due to properties of the initiator, and thus it is unfavorable in terms of optical durability and also corrosion may be generated in some substrates. Therefore, in consideration of those points, the content of the initiator may be selected in the proper content range.

As described above, the absorptive film of the present application may include a gettering layer, and the gettering layer may further include a binder resin. A type of the binder resin is not particularly limited as long as it has compatibility with other resins, such as a base resin. As the binder resin, a phenoxy resin, an acrylate resin, or a high molecular weight epoxy resin may be used. Here, the high molecular weight epoxy resin may refer to a resin having a weight average molecular weight of about 2,000 to 70,000 or 4,000 to 6,000, for example. Examples of the high molecular weight epoxy resin may include a solid bisphenol A-type epoxy resin or a solid bisphenol F-type epoxy resin. As the binder resin, a rubber component, such as a high polarity functional group-containing rubber or a high polarity functional group-containing reactive rubber may be used. In one example, as the binder resin, a phenoxy resin may be used.

When the binder resin is included, the ratio thereof is controlled according to a desired physical property, but is not particularly limited. For example, the binder resin may be included in the amount of about 200 parts by weight or less, about 150 parts by weight or less, or about 100 parts by weight or less, with respect to 100 parts by weight of the base resin. When the ratio of the binder resin is 200 parts by weight or less, it is possible to effectively maintain the compatibility with the base resin and to play a role as an adhesive layer.

In addition, the present application relates to an organic electronic device including the absorptive film. The exemplary organic electronic device of the present application includes a substrate, a transparent electrode layer provided on the substrate, an organic layer that is provided on the transparent electrode layer and at least includes an emitting layer, and a reflective electrode layer provided on the organic layer, in which an absorptive film may be provided between the substrate and the transparent electrode layer or on the top of the reflective electrode layer. When the transparent electrode layer and reflective electrode layer are configured as described above, it is possible to implement the bottom emitting device, in which the light generated in the emitting layer of the organic layer is emitted to the side of substrate.

In one embodiment of the present application, the absorptive film may be provided between the substrate and the transparent electrode layer and also on the top of the reflective electrode layer. By further including the absorptive film, an effect of absorbing and blocking moisture from the outside becomes excellent.

In addition, an exemplary organic electronic device of the present application includes a substrate, a reflective electrode layer provided on the substrate, an organic layer that is provided on the reflective electrode layer and at least includes an emitting layer, and an transparent electrode layer provided on the organic layer, in which an absorptive film may be provided on the transparent electrode layer. When the transparent electrode layer and reflective electrode layer are configured as described above, it is possible to implement the top emitting device, in which the light generated in the emitting layer of the organic layer is emitted to the side of transparent electrode layer.

Here, since the light generated in the emitting layer of the organic layer is emitted to the side of the transparent electrode layer, the absorptive film should satisfy the transparency in the case of the top emitting device. The absorptive film according to the present application includes the first moisture absorbent particles and the second moisture absorbent particles having a specific size, and thus, it is possible to implement the top emitting device.

In one specific embodiment of the present application, the absorptive film may be further provided between the reflective electrode layer and the substrate.

The organic electronic device of the present application may have the structure having an organic layer including at least an emitting layer, which is positioned between a hole-injection electrode layer and an electron-injection electrode layer. For example, when the electrode layer on the top of the substrate is a hole-injection electrode layer, the electrode layer on the other side thereof may be an electron-injection electrode layer, and on the contrary, when the electrode layer on the top of the substrate is an electron-injection electrode layer, the electrode layer on the other side thereof may be a hole-injection electrode layer.

The organic layer provided between the electron- and hole-injection electrode layer may include at least one emitting layer. The organic layer may include two or more plurality of emitting layers. When two or more emitting layers are included, the emitting layers may have the structure, in which the layers are divided by an intermediate electrode layer or charge generating layer (CGL) having a charge-generating property.

The emitting layer may be formed using various fluorescence or phosphorescence organic materials that are known in the art, for example. Examples of the materials for forming the emitting layer may include Alq-based materials, such as, tris(4-methyl-8-quinolinolate)aluminum (III) (Alg3), 4-MAlq3 or Gaq3, a cyclopenadiene derivative, such as, C-545T($C_{26}H_{26}N_2O_2S$), DSA-amine, TBSA, BTP, PAP-NPA, spiro-FPA, $Ph_3Si$(PhTDAOXD), or 1,2,3,4,5-pentaphenyl-1,3-cyclopentadiene (PPCP), DPVBi(4,4'-bis(2,2'-diphenylyinyl)-1,1'-biphenyl), distyrylbenzene or a derivative thereof, or DCJTB(4-(Dicyanomethylene)-2-tert-butyl-6-(1,1,7,7,-tetramethyljulolidyl-9-enyl)-4H-pyran), DDP, AAAP, or NPAMLI; or a phosphorescence material, such as, Firpic, m-Firpic, N-Firpic, $bon_2Ir(acac)$, $(C_6)_2Ir(acac)$, $bt_2Ir(acac)$, $dp_2Ir(acac)$, $bzq_2Ir(acac)$, $bo_2Ir(acac)$, $F_2Ir(bpy)$, $F_2Ir(acac)$, $op_2Ir(acac)$, $ppy_2Ir(acac)$, $tpy_2Ir(acac)$, FIrppy(fac-tris[2-(4,5'-difluorophenyl)pyridine-C',N] iridium(III)), or $Btp_2Ir(acac)$(bis(2-(2'-benzo[4,5-a]thienyl)pyridinato-N,C3') iridium(acetylactonate)), but the present invention is not limited thereto. The emitting layer may have a host-dopant system including the above materials as a host and perylene, distyrylbiphenyl, DPT, quinacridone, rubrene, BTX, ABTX, or DCJTB as a dopant.

In addition, the emitting layer may be formed by properly using a type exhibiting an emitting property among electron-accepting organic compounds or electron-donating organic compounds.

The organic layer may be formed in various structures, further including other various functional layers that are known in the art as long as it includes an emitting layer. Examples of the layer that can be included in an organic layer may include an electron injection layer, a hole blocking layer, an electron transporting layer, a hole transporting layer, and a hole injection layer.

Various materials for forming a hole or electron injection electrode layer and an organic layer, for example, an emitting layer, an electron injection or transporting layer, and a hole injection or transporting layer, and the methods for manufacturing the same are known in the art, and may be used without limit.

The organic electronic device may further include an encapsulation structure. The encapsulation structure may be a protection structure that blocks the inflow of foreign materials, such as moisture or oxygen, into the organic layer of the organic electronic device. For example, the encapsulation structure may be a can, such as a glass can or a metal can, or a film covering the front side of the organic layer.

FIG. 2 illustrates an exemplary type, in which a substrate 21, a transparent electrode layer 22, an organic layer 23 provided on the transparent electrode layer 22, and a reflective electrode layer 24, which are formed in order, are protected by an encapsulation structure 25 having a can structure, such as a glass can or a metal can, and an absorptive film 26 is provided between the transparent electrode layer 22 and the substrate 21. As illustrated in FIG. 2, the encapsulation structure 25 may be attached on the substrate by an adhesive, for example. In addition, the sides of the organic layer and the electrode layer may be sealed by an adhesive. In such a way, a protection effect may be maximized through an encapsulation structure.

FIG. 3 illustrates an exemplary type, in which a substrate 21, an absorptive film 26, a reflective electrode layer 24, an organic layer 23 formed on the reflective electrode layer 24, a transparent electrode layer 22, and an absorptive film 26, which are formed in order, are protected by an encapsulation structure 25 having a can structure, such as a glass can or a metal can.

[Effects]

The present application can provide a reliable film by suppressing sudden moisture absorption of a gettering agent during the process for manufacturing an absorptive film. In addition, the absorptive film including the gettering agent is positioned on the front side or back side of an organic electronic device, and thus, effectively blocks moisture, and thus, the lifespan and durability of the organic electronic device can be improved. In addition, the absorptive film according to the present application secures transparency, and thus, can be positioned even on the side that emits light. Therefore, it is possible to implement a top emitting device.

[Description of Drawings]

FIG. 1 illustrates a diagram illustrating an exemplary absorptive film according to the present application.
FIGS. 2 and 3 illustrate diagrams illustrating an exemplary organic electronic device according to the present application.

[Description of Reference Numerals]

1, 26: absorptive film
11: gettering layer
12: releasing film
21: substrate
22: transparent electrode layer
23: organic layer
24: reflective electrode layer
25: encapsulation structure

[Modes of the Invention]

Hereinafter, the present application will be described in more detail with reference of Examples according to the present application and Comparative Examples not according to the present application, but the scope of the present application is not limited to the following Examples.

**Example 1**

1. Preparation of moisture absorbent particle

A CaO slurry was prepared by adding 3 g of CaO (first moisture absorbent particle) powder having a size of 30 nm to 100 ml of an anhydrous ethanol and then performing a ball mill process for 24 hours. 3 ml of the solution prepared by dissolving $Mg(OCH_3)_2$ in methanol to be 10 wt% was added to the CaO slurry and then, stirred for 3 hours, such that second moisture absorbent particles were subjected to the surface treatment of CaO. 0.5 ml of an acetic acid solution was added thereto, and then, further stirred for 2 hours. The reactant thus obtained was separated by using a centrifuge to separate a solid content and a solvent, and then, the solid content was dried in a vacuum dryer device while maintaining the temperature of the device at 80°C. The dried solid content was subjected to calcinations under a nitrogen atmosphere at 700°C for 15 minutes, such that the surface treatment was performed on the second moisture absorbent particle to have the thickness of 10 nm. The first moisture absorbent particle that was surface-treated with the second moisture absorbent particle was obtained.

2. Preparation of solution of gettering layer

The moisture absorbent particles (the first moisture absorbent particles that were surface-treated with the second moisture absorbent particles) prepared as described above were dispersed in a solvent. In addition, separately, a solution (solid content of 70%), which was prepared by diluting 100 g of an epoxy resin (YD-128, manufactured by Kukdo Chemical) and 70 g of a phenoxy resin (YP-70, manufactured by Dongdo Chemical) with methylethylketone, was prepared, and then, homogenized. 250 g of the ready-made moisture absorbent particle solution was added to the homogenized solution thus obtained, and then, 5 g of imidazole (Shikoku Chemicals) that is a curing agent was added thereto. Since then, the solution thus obtained was stirred at a high speed for 1 hour to prepare a solution of gettering layer.

3. Preparation of absorptive film

The solution of gettering layer that was prepared as described above was applied on the releasing side of releasing PET using a comma coater and dried in a dryer at 130°C for 3 minutes to obtain an absorptive film including a gettering layer having a thickness of 50 $\mu$m.

**Example 2**

A moisture absorbent particle and an absorptive film including the same were prepared in the same method as Example 1, except that 0.5 ml of the solution that was dissolved with 10 wt% of $Mg(OCH_3)_2$ was added to methanol.

**Comparative Example 1**

An absorptive film was prepared in the same method as Example 1, except that CaO powder having a size of 30 nm was not subjected to a surface treatment.

**Comparative Example 2**

An absorptive film was prepared in the same method as Example 1, except that CaO powder having a size of 200 nm was not subjected to a surface treatment.

**Comparative Example 3**

An absorptive film was prepared in the same method as Comparative Example 1, except that CaO powder having a size of 1 $\mu$m was used.

**Experimental Example 1**

1 g of each of the gettering agents (0 wt% of the moisture content) prepared in Examples and Comparative Examples was added to a vial, and then, the vial without putting a top thereon was put in a constant temperature and humidity chamber. The constant temperature and humidity chamber was maintained at the temperature of 25°C and the humidity of 70%. The time-based masses of the vials containing the samples were measured, and the moisture content was measured initially 1 hour after the beginning, and then, was defined as an initial rate of moisture absorption and compared. It was confirmed that 72 hours later, there were no mass increases. At this time, the amount of moisture absorption was defined as a total amount of moisture absorption, and then, compared.

**Experimental Example 2**

The light transmittances of the absorptive films prepared in Examples and Comparative Examples were measured at 440 nm using a UV-Vis spectrometer, and the hazes thereof were measured according to the standard test method of ASTM D 1003.

[Table 1]

|  | Initial rate of moisture absorption (wt%) | Total amount of moisture absorption (wt%) |
|---|---|---|
| Example 1 | 4.3 | 34.3 |
| Example 2 | 3.2 | 34.1 |
| Com. Example 1 | 11.6 | 34.9 |
| Com. Example 2 | 8.2 | 34.5 |
| Com. Example 3 | 4.1 | 34.3 |

[Table 2]

|  | Light transmittance (%) | Haze (%) |
|---|---|---|
| Example 1 | 90 | 2.3 |
| Example 2 | 90 | 2.4 |
| Com. Example 1 | 88.4 | 4.1 |
| Corn. Example 2 | 87.3 | 6.2 |
| Com. Example 3 | 65.4 | 21.6 |

As listed in Table 1, it can be confirmed that when the moisture absorbent particles having a nano size is the types of the moisture absorbent particles prepared in Examples 1 and 2, the initial rates of moisture absorption were 4.3 wt% and 3.2 wt%, respectively, which was significantly suppressed as compared with Comparative Examples 1 and 2 without any sort of treatments. However, it can be confirmed that the total amount of moisture absorption after a substantial amount of time has lapsed is barely decreased. For this reason, it can be expected that the decrease in the amount of moisture absorption of the moisture absorbent particles can be prevented even when a process for manufacturing a device is performed in the atmosphere, not the extremely dried atmosphere.

In addition, as listed in Table 2, it can be confirmed from the result of measuring light transmittances and hazes of the absorptive films prepared in Examples and Comparative Examples that the absorptive films of Examples 1 and 2 using the particles exhibit excellent light transmittances, but the light transmittances of the films of Comparative Examples 2 and 3 are significantly decreased.

From the results of Experimental Examples, it can be confirmed that it is possible to prepare a transparent absorptive film that can be applied to a top-emission OLED using moisture absorbent particles having a nano size, and by forming a protection layer with moisture absorbent particles having a low rate of moisture absorption on the surface of first nano moisture absorbent particles, it is possible to obtain an effect of suppressing the particle alteration generated due to a sudden moisture absorption during performing a device-manufacturing process in the general atmosphere.

## Claims

1.  An absorptive film comprising a gettering layer having a gettering agent,
    wherein the gettering agent comprises first moisture absorbent particles, which have an average particle size in a range of 20 nm to 100 nm; and second moisture absorbent particles, which surround a surface of each first moisture absorbent particle and have a lower rate of moisture absorption than the first moisture absorbent particles,
    wherein the first moisture absorbent particle is CaO and the second moisture absorbent particle is MgO,
    wherein the particle size of the particles is measured by a scanning electron microscope (SEM) image,
    wherein the rate of moisture absorption of the first and the second absorbent particles is calculated after the first or second moisture absorbent particles in a state of having a moisture content of 0 to 0.1 wt% are maintained at 25°C and a relative humidity of 70% for 1 hour, and
    wherein the gettering agent has 8 wt% or less of a moisture content, which is calculated after the gettering agent in a state of having the moisture content of 0 to 0.1 wt% is maintained at 25°C and a relative humidity of 70% for 1 hour.

2.  The absorptive film of claim 1, wherein the gettering agent satisfies the following Equation 1:

[Equation 1]

$$Y/X \geq 7$$

where, in Equation 1, X represents a moisture content in a gettering agent, which is calculated after the gettering agent in a state of having the moisture content of 0 to 0.1 wt% is maintained at 25°C and a relative humidity of 70% for 1 hour, and Y represents the moisture content in a gettering agent, which is calculated after the gettering agent in the state of having the moisture content of 0 to 0.1 wt% is maintained at 25°C and a relative humidity of 70% for 72 hours.

3. The absorptive film of claim 1, wherein, in the gettering agent, the first moisture absorbent particles have 10 wt% to 30 wt% of a moisture content, which is calculated after the first moisture absorbent particles in a state of having the moisture content of 0 to 0.1 wt% are maintained at 25°C and a relative humidity of 70% for 1 hour.

4. The absorptive film of claim 1, wherein, in the gettering agent, the second moisture absorbent particles have 1 wt% to 9 wt% of a moisture content, which is calculated after the second moisture absorbent particles in a state of having the moisture content of 0 to 0.1 wt% are maintained at 25°C and a relative humidity of 70% for 1 hour.

5. The absorptive film of claim 1, wherein, in the gettering agent, the rate of moisture absorption of the first moisture absorbent particles is 2 times to 20 times higher than a rate of moisture absorption of the second moisture absorbent particles.

6. The absorptive film of claim 1, wherein, in the gettering agent, the second moisture absorbent particles are comprised in an amount of 5 to 20 parts by weight with respect to 100 parts by weight of the first moisture absorbent particles.

7. The absorptive film of claim 1, having light transmittance of 88% or more with respect to a visible ray area, wherein the light transmittance is measured at 440 nm using a UV-Vis spectrometer.

8. The absorptive film of claim 1, wherein a haze is less than 3%, wherein the haze is measured according to ASTM D1003.

9. An organic electronic device comprising the absorptive film of claim 1.

10. The organic electronic device of claim 9, comprising a substrate, a transparent electrode layer provided on the substrate, an organic layer, which is provided on the transparent electrode layer and at least comprises an emitting layer, and a reflective electrode layer provided on the organic layer,
wherein the absorptive film is provided between the substrate and the transparent electrode layer and/or on the top of the reflective electrode layer.

11. The organic electronic device of claim 9, comprising a substrate, a reflective electrode layer provided on the substrate, an organic layer, which is provided on the reflective electrode layer and at least includes an emitting layer, and a transparent electrode layer provided on the organic layer,
wherein the absorptive film is provided on the top of the transparent electrode layer.

12. The organic electronic device of claim 11, further comprising the absorptive film between the reflective electrode layer and the substrate.

**Patentansprüche**

1. Absorptionsfähiger Film, umfassend eine Getteringschicht mit einem Getteringagens, wobei das Getteringagens erste feuchtigkeitsabsorbierende Teilchen, die eine durchschnittliche Teilchengröße in einem Bereich von 20 nm bis 100 nm aufweisen; und zweite feuchtigkeitsabsorbierende Teilchen, die eine Oberfläche jedes ersten feuchtigkeitsabsorbierenden Teilchens umgeben und eine geringere Feuchtigkeitsabsorptionsrate als die ersten feuchtigkeitsabsorbierenden Teilchen aufweisen, umfasst,
wobei das erste feuchtigkeitsabsorbierende Teilchen CaO und das zweite feuchtigkeitsabsorbierende Teilchen MgO ist,
wobei die Teilchengröße der Teilchen durch Rasterelektronenmikroskopiebildgebung (SEM) gemessen wird,

wobei die Feuchtigkeitsabsorptionsrate der ersten und der zweiten absorbierenden Teilchen berechnet wird, nachdem die ersten oder zweiten feuchtigkeitsabsorbierenden Teilchen in einem Zustand mit einem Feuchtigkeitsgehalt von 0 bis 0,1 Gew.-% bei 25°C und relativer Feuchtigkeit von 70% für eine Stunde gehalten werden, und wobei das Getteringagens 8 Gew.-% oder weniger an einem Feuchtigkeitsgehalt aufweist, der berechnet wird, nachdem das Getteringagens in einem Zustand mit dem Feuchtigkeitsgehalt von 0 bis 0,1 Gew.-% bei 25°C und einer relativen Feuchtigkeit von 70% für eine Stunde gehalten wird.

2. Absorptionsfähiger Film nach Anspruch 1, wobei das Getteringagens die folgende Gleichung 1 erfüllt:

[Gleichung 1]

$$Y/X \geq 7,$$

wobei in Gleichung 1 X einen Feuchtigkeitsgehalt in einem Getteringagens darstellt, der berechnet wird, nachdem das Getteringagens in einem Zustand mit dem Feuchtigkeitsgehalt von 0 bis 0,1 Gew.-% bei 25°C und einer relativen Feuchtigkeit von 70% für 1 Stunde gehalten wird, und Y den Feuchtigkeitsgehalt in einem Getteringagens darstellt, der berechnet wird, nachdem das Getteringagens in dem Zustand mit dem Feuchtigkeitsgehalt von 0 bis 0,1 Gew.-% bei 25°C und einer relativen Feuchtigkeit von 70% für 72 Stunden gehalten wird.

3. Absorptionsfähiger Film nach Anspruch 1, wobei in dem Getteringsagens die ersten feuchtigkeitsabsorbierenden Teilchen 10 Gew.-% bis 30 Gew.-% eines Feuchtigkeitsgehalts aufweisen, der berechnet wird, nachdem die feuchtigkeitsabsorbierenden Teilchen in einem Zustand mit dem Feuchtigkeitsgehalt von 0 bis 0,1 Gew.-% bei 25°C und einer relativen Feuchtigkeit von 70% für eine Stunden gehalten werden.

4. Absorptionsfähiger Film nach Anspruch 1, wobei in dem Getteringsagens die zweiten feuchtigkeitsabsorbierenden Teilchen 1 Gew.-% bis 9 Gew.-% eines Feuchtigkeitsgehalts aufweisen, der berechnet wird, nachdem die zweiten feuchtigkeitsabsorbierenden Teilchen in einem Zustand mit dem Feuchtigkeitsgehalt von 0 bis 0,1 Gew.-% bei 25°C und einer relativen Feuchtigkeit von 70% für eine Stunden gehalten werden.

5. Absorptionsfähiger Film nach Anspruch 1, wobei in dem Getteringsagens die Rate an Feuchtigkeitsabsorption der ersten feuchtigkeitsabsorbierenden Teilchen 2- bis 20-fach höher ist als eine Rate der Feuchtigkeitsabsorption der zweiten feuchtigkeitsabsorbierenden Teilchen.

6. Absorptionsfähiger Film nach Anspruch 1, wobei in dem Getteringsagens die zweiten feuchtigkeitsabsorbierenden Teilchen in einer Menge von 5 bis 20 Gewichtsteilen in Bezug auf 100 Gewichtsteile der ersten feuchtigkeitsabsorbierenden Teilchen umfasst sind.

7. Absorptionsfähiger Film nach Anspruch 1, mit Lichtdurchlässigkeit von 88% oder mehr in Bezug auf einen sichtbaren Strahlenbereich, wobei die Lichtdurchlässigkeit bei 440 nm unter Verwendung eines UV-Vis-Spektrometers gemessen wird.

8. Absorptionsfähiger Film nach Anspruch 1, wobei eine Trübung kleiner als 3% ist, wobei die Trübung gemäß ASTM D1003 gemessen wird.

9. Organische elektronische Vorrichtung, umfassend den absorptionsfähigen Film nach Anspruch 1.

10. Organische elektronische Vorrichtung nach Anspruch 9, umfassend ein Substrat, eine transparente Elektrodenschicht, die auf dem Substrat bereitgestellt ist, eine organische Schicht, die auf der transparenten Elektrodenschicht bereitgestellt ist und wenigstens eine emittierende Schicht umfasst, und eine Reflektivelektrodenschicht, die auf der organischen Schicht bereitgestellt ist, wobei der absorptionsfähige Film zwischen dem Substrat und der transparenten Elektrodenschicht und/oder auf der Oberseite der Reflektivelektrodenschicht bereitgestellt ist.

11. Organische elektronische Vorrichtung nach Anspruch 9, umfassend ein Substrat, eine Reflektivelektrodenschicht, die auf dem Substrat bereitgestellt ist, eine organische Schicht, die auf der Reflektivelektrodenschicht bereitgestellt ist und wenigstens eine emittierende Schicht einschließt, und eine transparente Elektrodenschicht, die auf der organischen Schicht bereitgestellt ist,
wobei der absorptionsfähige Film auf der Oberseite der transparenten Elektrodenschicht bereitgestellt ist.

**12.** Organische elektronische Vorrichtung nach Anspruch 11, weiter umfassend den absorptionsfähigen Film zwischen der Reflektivelektrodenschicht und dem Substrat.


**Revendications**

**1.** Film absorbant comprenant une couche piégeuse contenant un agent piégeur,
dans lequel l'agent piégeur comprend des premières particules absorbant l'humidité, qui ont une taille de particule moyenne comprise dans l'intervalle de 20 nm à 100 nm ; et des deuxièmes particules absorbant l'humidité, qui entourent une surface de chaque première particule absorbant l'humidité et qui ont un taux d'absorption de l'humidité plus bas que celui des premières particules absorbant l'humidité,
dans lequel la première particule absorbant l'humidité est CaO et la deuxième particule absorbant l'humidité est MgO,
dans lequel la dimension particulaire des particules est mesurée par une photo prise par balayage au microscope électronique (SEM),
dans lequel le taux d'absorption de l'humidité des premières et des deuxièmes particules absorbantes est calculé après que les premières ou les deuxièmes particules absorbant l'humidité dans un état de présenter une teneur en humidité de 0 à 0,1 % en poids ont été maintenues à 25 °C et à une humidité relative de 70 % pendant une heure, et dans lequel l'agent piégeur a une teneur en humidité de 8 % en poids ou inférieure, celle-ci étant calculée après que l'agent piégeur dans un état de présenter la teneur en humidité de 0 à 0,1 % en poids a été maintenu à 25 °C et à une humidité relative de 70 % pendant une heure.

**2.** Film absorbant selon la revendication 1, dans lequel l'agent piégeur satisfait à l'équation 1 suivante :

$$[\text{Équation 1}]$$

$$Y/X \geq 7$$

où, dans l'équation 1, X représente une teneur en humidité dans un agent piégeur, qui est calculée après que l'agent piégeur dans un état de présenter la teneur en humidité de 0 à 0,1 % en poids a été maintenu à 25 °C et à une humidité relative de 70 % pendant une heure, et Y représente la teneur en humidité dans un agent piégeur, qui est calculée après que l'agent piégeur dans l'état de présenter la teneur en humidité de 0 à 0,1 % en poids a été maintenu à 25 °C et à une humidité relative de 70 % pendant 72 heures.

**3.** Film absorbant selon la revendication 1, dans lequel dans l'agent piégeur, les premières particules absorbant l'humidité ont une teneur en humidité de 10 % en poids à 30 % en poids qui est calculée après que les premières particules absorbant l'humidité dans un état de présenter une teneur en humidité de 0 à 0,1 % en poids ont été maintenues à 25 °C et à une humidité relative de 70 % pendant une heure.

**4.** Film absorbant selon la revendication 1, dans lequel, dans l'agent piégeur, les deuxièmes particules absorbant l'humidité ont une teneur en humidité de 1 % en poids à 9 % en poids qui est calculée après que les deuxièmes particules absorbant l'humidité dans un état de présenter une teneur en humidité de 0 à 0,1 % en poids ont été maintenues à 25 °C et à une humidité relative de 70 % pendant une heure.

**5.** Film absorbant selon la revendication 1, dans lequel, dans l'agent piégeur, le taux d'absorption de l'humidité des premières particules absorbant l'humidité est 2 fois à 20 fois plus élevé qu'un taux d'absorption de l'humidité des deuxièmes particules absorbant l'humidité.

**6.** Film absorbant selon la revendication 1, dans lequel, dans l'agent piégeur, les deuxièmes particules absorbant l'humidité sont comprises en une quantité de 5 à 20 parties en poids par rapport à 100 parties en poids des premières particules absorbant l'humidité.

**7.** Film absorbant selon la revendication 1, ayant une transmittance de la lumière de 88 % ou supérieure par rapport à une zone de rayons visibles, la transmittance de la lumière étant mesurée à 440 nm en utilisant un spectromètre UV-Vis.

**8.** Film absorbant selon la revendication 1, dans lequel la nébulosité est inférieure à 3 %, ladite nébulosité étant mesurée selon la norme D1003 de l'ASTM.

**9.** Dispositif électronique organique comprenant le film absorbant selon la revendication 1.

**10.** Dispositif électronique organique selon la revendication 9, comprenant un substrat, une couche transparente d'électrode pourvue sur le substrat, une couche organique, qui est pourvue sur la couche transparente d'électrode et qui comprend au moins une couche émettrice, et une couche réfléchissante d'électrode pourvue sur la couche organique, dans lequel le film absorbant est pourvu entre le substrat et la couche transparente d'électrode et/ou sur le dessus de la couche réfléchissante d'électrode.

**11.** Dispositif électronique organique selon la revendication 9, comprenant un substrat, une couche réfléchissante d'électrode pourvue sur le substrat, une couche organique, qui est pourvue sur la couche réfléchissante d'électrode et au moins une couche émettrice, et une couche transparente d'électrode pourvue sur la couche organique, dans lequel le film absorbant est pourvu sur le dessus la couche transparente d'électrode.

**12.** Dispositif électronique organique selon la revendication 11, comprenant en outre le film absorbant entre la couche réfléchissante d'électrode et le substrat.

FIG. 1

FIG. 2

FIG. 3

# REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6226890 B
- US 6808828 B
- JP 2000145627 A
- JP 2001252505 A
- US 2006097633 A1
- US 2002035032 A1